# EUROPEAN PATENT APPLICATION

(11) **EP 4 557 913 A2**
(43) Date of publication of application: **21.05.2025**
(21) Application number: 24212310.7
(22) Date of filing: 12.11.2024
(51) Int. Cl.: H10D 88/00, H10D 89/10, H10D 84/01, H10D 84/83, H10D 30/43, H10D 64/27, H10D 84/03

(54) **CELL BLOCK FOR HIGH-PERFORMANCE SEMICONDUCTOR DEVICE**

(30) Priority: 20.11.2023 US 202363601065 P; 26.03.2024 US 202418617033
(71) Applicant: Samsung Electronics Co., Ltd., Suwon-si, Gyeonggi-do 16677 (KR)
(72) Inventor: KIM, Jintae, San Jose, CA, 95134 (US); SHIN, Hyo Jong, San Jose, CA, 95134 (US); PARK, Panjae, San Jose, CA, 95134 (US); SEO, Kang-ill, San Jose, CA, 95134 (US)
(74) Representative: Kuhnen & Wacker Patent- und Rechtsanwaltsbüro PartG mbB

(57) **Abstract**

Provided is a semiconductor device based on a cell block which may include: a 1^{st} cell comprising a 1^{st} lower active region and a 1^{st} upper active region above the 1^{st} lower active region in a 3^{rd} direction, both being extended in a 1^{st} direction; a 2^{nd} cell comprising a 2^{nd} lower active region and a 2^{nd} upper active region above the 2^{nd} lower active region in the 3^{rd} direction, both being extended in the 1^{st} direction; and a cell spacer between the 1^{st} cell and the 2^{nd} cell in a 2^{nd} direction, wherein no active region is formed in the cell spacer.

## Description

### BACKGROUND

### 1. Filed

Apparatuses consistent with example embodiments of the disclosure relate to a semiconductor cell block designed in consideration of local layout effect (LLE).

### 2. Description of Related Art

An integrated circuit of a semiconductor device includes a plurality of logic circuits (or logic gates) which perform one or more logic operations or functions such as AND, OR, NOT (inverter), NAND, NOR, XOR, XNOR, AOI, multiplexing, and their combination, not being limited thereto. These logic circuits are a building block of the integrated circuit, and may be implemented in one or more semiconductor cells or a semiconductor cell block. Hereafter, a semiconductor cell and a semiconductor cell block are referred to as a cell and a cell block, respectively. Also, a cell may refer to a standard cell for a cell library used in designing an integrated circuit or a cell architecture for a semiconductor device. A cell for an integrated circuit may include one or more active regions and gate structures forming one or more of passive devices and transistors configured to perform a logic operation or function.

In a cell architecture for a semiconductor device, a cell block for one or more logic circuits may often be surrounded by or placed adjacent to one or more other cells. The layout of these cells with respect to the cell block including their proximity to the cell block affects a performance of the semiconductor device implemented by the cell block. This is referred to as a local layout effect (LLE) or layout dependence effect (LDE).

As the sizes of a cell and a cell block are decreased in response to demand for high-density semiconductor devices, the influence of the LLE increases, and thus, a cell layout that can minimize the LLE on a cell block and improve a performance of a semiconductor device to be formed based on the cell layout is required, particularly, when a semiconductor device is formed by a three-dimensional (3D) transistor structure or multi-stack transistor structure.

Information disclosed in this Background section has already been known to the inventors before achieving the embodiments of the present application or is technical information acquired in the process of achieving the embodiments described herein. Therefore, it may contain information that does not form prior art that is already known to the public.

### SUMMARY

Various example embodiments provide a semiconductor device based on a cell block including a plurality of cells which are formed considering a local layout effect (LLE).

According to one or more embodiments, there is provided a semiconductor device based on a cell block which may include: a 1^{st} cell including a 1^{st} lower active region and a 1^{st} upper active region extended in a 1^{st} direction, a width of the 1^{st} upper active region being smaller than a width of the 1^{st} lower active region in a 2^{nd} direction, and the 1^{st} upper active region partially overlapping the 1^{st} lower active region in a 3^{rd} direction; and a 2^{nd} cell abutting the 1^{st} cell in the 2^{nd} direction, and including a 2^{nd} lower active region and a 2^{nd} upper active region extended in the 1^{st} direction, a width of the 2^{nd} upper active region being smaller than a width of the 2^{nd} lower active region in the 2^{nd} direction, and the 2^{nd} upper active region partially overlapping the 2^{nd} lower active region in the 3^{rd} direction, wherein the 3^{rd} direction vertically intersects the 1^{st} direction and the 2^{nd} direction which horizontally intersect each other, and wherein the 2^{nd} cell is oriented with respect to the 1^{st} cell in the 2^{nd} direction such that a 1^{st} region, above the 1^{st} lower active region, not overlapped by the 1^{st} upper active region in the 1^{st} cell faces a 2^{nd} region, above the 2^{nd} lower active region, not overlapped by the 2^{nd} upper active region in the 2^{nd} cell, in the 2^{nd} direction.

According to one or more embodiments, there is provided a semiconductor device based on a cell block which may include: a 1^{st} cell including a 1^{st} lower active region and a 1^{st} upper active region extended in a 1^{st} direction, a width of the 1^{st} upper active region being smaller than a width of the 1^{st} lower active region in a 2^{nd} direction, and the 1^{st} upper active region partially overlapping the 1^{st} lower active region in a 3^{rd} direction; and a 2^{nd} cell abutting the 1^{st} cell in the 2^{nd} direction, and including a 2^{nd} lower active region and a 2^{nd} upper active region extended in the 1^{st} direction, a width of the 2^{nd} upper active region being smaller than a width of the 2^{nd} lower active region in the 2^{nd} direction, and the 2^{nd} upper active region partially overlapping the 2^{nd} lower active region in the 3^{rd} direction, wherein the width of the 2^{nd} upper active region is smaller than the width of the 1^{st} upper active region, and wherein the width of the 2^{nd} lower active region is smaller than the width of the 1^{st} lower active region.

According to one or more embodiments, there is provided a semiconductor device based on a cell block which may include: a 1^{st} cell comprising a 1^{st} lower active region and a 1^{st} upper active region above the 1^{st} lower active region in a 3^{rd} direction, both being extended in a 1^{st} direction; a 2^{nd} cell comprising a 2^{nd} lower active region and a 2^{nd} upper active region above the 2^{nd} lower active region in the 3^{rd} direction, both being extended in the 1^{st} direction; and a cell spacer between the 1^{st} cell and the 2^{nd} cell in a 2^{nd} direction, wherein no active region is formed in the cell spacer.

According to one or more embodiments, the 1^{st} upper active region may have a smaller width than the 1^{st} lower active region in the 2^{nd} direction such that the 1^{st} upper active region partially overlaps the 1^{st} lower active region in the 3^{rd} direction, and the 2^{nd} upper active region may also have a smaller width than the 2^{nd} lower active region in the 2^{nd} direction such that the 1^{st} upper active region partially overlaps the 1^{st} lower active region in the 3^{rd} direction.

According to one or more embodiments, the 2^{nd} cell may be in a flipped form of the 1^{st} cell in the 2^{nd} direction such that a region, above the 1^{st} lower active region, not overlapped by the 1^{st} upper active region faces a region, above the 2^{nd} lower active region, not overlapped by the 2^{nd} upper active region in the 2^{nd} direction.

### BRIEF DESCRIPTION OF DRAWINGS

Example embodiments of the disclosure will be more clearly understood from the following detailed description taken in conjunction with the accompanying drawings in which:
FIG. 1A illustrates a layout of a cell block formed of a plurality of cells for a two-dimensional (2D) semiconductor device, according to one or more embodiments;
FIG. 1B illustrates a layout of a variant of the cell block of FIG. 1A, according to one or more embodiments;
FIG. 2A illustrates a layout of a cell block formed of a plurality of cells for a three-dimensionally-stacked (3D-stacked) semiconductor device, according to one or more embodiments;
FIG. 2B illustrates a layout of a variant of the cell block of FIG. 2A, according to one or more embodiments;
FIG. 2C illustrates an upper channel structure formed on an upper active region for an upper nanosheet transistor and a lower channel structure formed on a lower active region for a lower nanosheet transistor in a cross-section view taken along a line I-I' shown in FIG. 2A;
FIG. 2D illustrates an upper source/drain region formed on an upper active region for an upper nanosheet transistor and a lower source/drain region formed on a lower active region for a lower nanosheet transistor in a cross-section view taken along a line II-II' shown in FIG. 2A
FIGS. 3A illustrates a layout of a cell block formed of a plurality of cells and cell spacers for a 3D-stacked semiconductor device, according to one or more embodiments;
FIG. 3B illustrates a layout of a variant of the cell block of FIG. 3A, according to one or more embodiments; and
FIG. 4 is a schematic block diagram illustrating an electronic device including at least one 3D-stacked semiconductor device formed based on at least one of the cell blocks 20A, 20B, 30A and 30B shown in FIGS. 2A, 2B, 3A and 3B, according to embodiments.

### DETAILED DESCRIPTION

The embodiments of the disclosure described herein are example embodiments, and thus, the disclosure is not limited thereto, and may be realized in various other forms. Each of the embodiments provided in the following description is not excluded from being associated with one or more features of another example or another embodiment also provided herein or not provided herein but consistent with the disclosure. For example, even if matters described in a specific example or embodiment are not described in a different example or embodiment thereto, the matters may be understood as being related to or combined with the different example or embodiment, unless otherwise mentioned in descriptions thereof. In addition, it should be understood that all descriptions of principles, aspects, examples, and embodiments of the disclosure are intended to encompass structural and functional equivalents thereof. In addition, these equivalents should be understood as including not only currently well-known equivalents but also equivalents to be developed in the future, that is, all devices invented to perform the same functions regardless of the structures thereof.

It will be understood that when an element, component, layer, pattern, structure, region, or so on (hereinafter collectively "element") of a semiconductor device is referred to as being "over," "above," "on," "below," "under," "beneath," "connected to" or "coupled to" another element the semiconductor device, it can be directly over, above, on, below, under, beneath, connected or coupled to the other element or an intervening element(s) may be present. In contrast, when an element of a semiconductor device is referred to as being "directly over," "directly above," "directly on," "directly below," "directly under," "directly beneath," "directly connected to" or "directly coupled to" another element of the semiconductor device, there are no intervening elements present. Like numerals refer to like elements throughout this disclosure.

Spatially relative terms, such as "over," "above," "on," "upper," "below," "under," "beneath," "lower," "left," "right," "lower-left," "lower-right," "upper-left," "upper-right," "central," "middle," and the like, may be used herein for ease of description to describe one element's relationship to another element(s) as illustrated in the figures. It will be understood that the spatially relative terms are intended to encompass different orientations of a semiconductor device in use or operation in addition to the orientation depicted in the figures. For example, if the semiconductor device in the figures is turned over, elements described as "below" or "beneath" other elements would then be oriented "above" the other elements. Thus, the term "below" can encompass both an orientation of above and below. The semiconductor device may be otherwise oriented (rotated 90 degrees or at other orientations) and the spatially relative descriptors used herein interpreted accordingly. As another example, when elements referred to as a "left" element and a "right" element" may be a "right" element and a "left" element when a device or structure including these elements are differently oriented. Thus, in the descriptions herebelow, the "left" element and the "right" element may also be referred to as a "1^{st}" element or a "2^{nd}" element, respectively, as long as their structural relationship is clearly understood in the context of the descriptions. Similarly, the terms a "lower" element and an "upper" element may be respectively referred to as a "1^{st}" element and a "2^{nd}" element with necessary descriptions to distinguish the two elements.

It will be understood that, although the terms "1^{st}," "2^{nd}," "3^{rd}," "4^{th}," "5^{th}," etc. may be used herein to describe various elements, these elements should not be limited by these terms. These terms are only used to distinguish one element from another element. Thus, a 1^{st} element discussed below could be termed a 2^{nd} element without departing from the teachings of the disclosure.

As used herein, expressions such as "at least one of," when preceding a list of elements, modify the entire list of elements and do not modify the individual elements of the list. For example, the expression, "at least one of a, b and c," should be understood as including only a, only b, only c, both a and b, both a and c, both b and c, or all of a, b and c. Herein, when a term "same" is used to compare a dimension of two or more elements, the term may cover a "substantially same" dimension.

It will be also understood that, even if a certain step or operation of manufacturing an apparatus or structure is described later than another step or operation, the step or operation may be performed later than the other step or operation unless the other step or operation is described as being performed after the step or operation.

Many embodiments are described herein with reference to schematic illustrations of the embodiments (and intermediate structures). As such, variations from the shapes of the illustrations as a result, for example, of manufacturing techniques and/or tolerances, are to be expected. Thus, the embodiments should not be construed as limited to the particular shapes of regions illustrated herein but are to include deviations in shapes that result, for example, from manufacturing. Various regions illustrated in the figures are schematic in nature and their shapes are not intended to illustrate the actual shape of a region of a device and are not intended to limit the scope of the disclosure. Further, in the drawings, the sizes and relative sizes of layers and regions may be exaggerated for clarity.

For the sake of brevity, conventional elements, structures or layers of a semiconductor device including a nanosheet transistor, a forksheet transistor and a fin field-effect transistor (FinFET) and materials forming the same may or may not be described in detail herein. For example, a certain isolation layer or structure of a semiconductor device and materials forming the same may be omitted herein when this layer or structure is not related to the novel features of the embodiments.

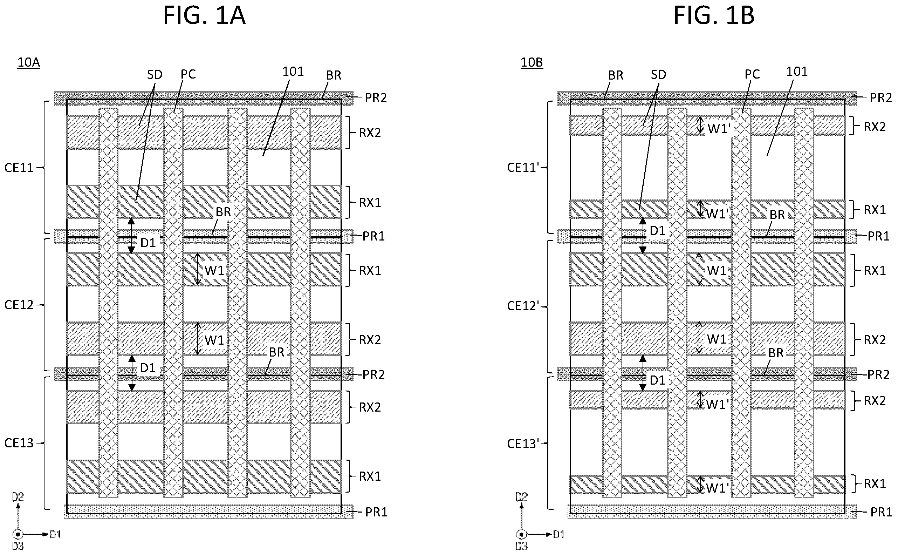

FIG. 1A illustrates a layout of a cell block formed of a plurality of cells for a two-dimensional (2D) semiconductor device, according to one or more embodiments, and FIG. 1B illustrates a layout of a variant of the cell block of FIG. 1A, according to one or more embodiments.

Referring to FIG. 1A, a cell block 10A is formed by serially arranging cells CE11-CE13 in a D2 direction, which is a cell-height direction or a channel-width direction. The cells CE11 and CE12 may abut each other in the D2 direction to share a boundary BR such that a lower boundary of the cell CE11 is or overlaps an upper boundary of the cell CE12. Similarly, the cells CE12 and CE13 may abut each other to share a boundary BR such that a lower boundary of the cell CE12 is or overlaps an upper boundary of the cell CE13. The upper boundary and the lower boundary of each of the cells CE11-CE13 define a cell height of the cell. In other words, a distance between these two boundaries is a cell height of the cell. Here, the upper boundary and the lower boundary of a cell refer to two boundaries of the cell opposite to each other in the D2 direction, that is, the cell-height direction, and is referred to as a 1^{st} boundary and a 2^{nd} boundary, respectively.

Each of the cells CE11-CE13 may include a 1^{st} active region RX1 for p-type metal-oxide-semiconductor transistors (PMOSs) or p-type field-effect transistors (PFETs) and a 2^{nd} active region RX2 for n-type metal-oxide-semiconductor transistors (NMOSs) or n-type field-effect transistors (NFETs). The two active regions RX1 and RX2 having a same width W1 in the D2 direction are arranged in two rows in each of the cells CE11-CE13 and extended in a D1 direction horizontally intersecting the D2 direction. The D1 direction refers to a cell-length direction or a channel-length direction.

Across the two active regions RX1 and RX2 in each of the cells CE11-CE13 may be formed a plurality of gate structures PC extended in the D2 direction. A portion of each of the two active regions RX1 and RX2 in each of the cells CE11-CE13 which a gate structure PC crosses or surrounds may form a channel region of a transistor structure, and two opposite regions in each of the active regions RX1 and RX2 with respect to the gate structure PC in the D1 direction may form source/drain regions connected to each other through the channel region. Here, the width W1 of each of the active regions RX1 and RX2 may be or correspond to a width of the channel region. Thus, these source/drain regions, the channel region and the gate structure may form a PMOS along the 1^{st} active region RX1 or an NMOS along the 2^{nd} active region RX2. Each of the PMOS and NMOS may be a fin field-effect transistor (FinFET), a nanosheet transistor, a different type of field-effect transistor or a planar transistor.

On each of the 1^{st} boundary and the 2^{nd} boundary of each of the cells CE11-CE13 may be disposed a 1^{st} power rail PR1 formed of a metal or metal compound connecting the cell to a positive voltage source VDD or a 2^{nd} power rail PR2 connecting the cell to a negative voltage source VSS or ground. The power rails PR1 and PR2 both are extended in the D1 direction and may overlap the 1^{st} boundary and the 2^{nd} boundary of each cell, respectively, in the D2 direction. The power rails PR1 and PR2 may be formed vertically above the active regions RX1, RX2 and the gate structures PC in the D3 direction on a front side of the 2D semiconductor device when this 2D semiconductor device is formed based on the cell block 10A, and thus the power rails PR1 and PR2 may be referred to as frontside power rails.

When a 2D semiconductor device is formed based on the cell block 10A, a region 101 on which the active regions RX1 and RX2 of the cells CE11-CE13 are formed will be a substrate, formed of silicon or its equivalent, or a backside isolation structure formed of a dielectric material such as silicon oxide. The backside isolation structure may be formed by replacing at least a portion of the substrate when a backside power distribution network (BSPDN) is formed on a back side of the 2D semiconductor device. Herein, the front side of a semiconductor device may refer to an area above a top surface of the substrate or the backside isolation structure where the active regions RX1, RX2 and the gate structures PC are formed, and the back side of a semiconductor device may refer to an area below a top surface of the substrate or the backside isolation structure.

Referring back to FIG. 1A, the 1^{st} cell CE11 may be formed by flipping the 2^{nd} cell CE12 in the D2 direction with respect to the 1^{st} boundary of the 2^{nd} cell CE12 which is the 2^{nd} boundary of the 1^{st} cell CE11, and similarly the 3^{rd} cell CE13 may be formed by flipping the 2^{nd} cell CE12 in the D2 direction with respect to the 2^{nd} boundary of the 2^{nd} cell CE12 which is the 1^{st} boundary of the 3^{rd} cell CE13. This cell flipping may be provided at least to shorten a signal routing path between two 1^{st} active regions RX1 or two 2^{nd} active regions RX2, thereby reducing contact resistance to improve connection performance and a device area gain.

In the meantime, electrical characteristics, performance, and a manufacturing process of a semiconductor device based on the cell block 10A may also be affected by a distance between two adjacent active regions respectively included in two adjacent cells in the D2 direction, which is referred to as RXRXV herein. The RXRXV in the cell block 10A may be a distance between the 1^{st} active regions RX1 of the cells CE11 and CE12 in the D2 direction, and a distance between the 2^{nd} active regions RX2 of the cells CE12 and CE13 in the D2 direction. Performance of a semiconductor device may increase when the RXRXV in a cell block for the semiconductor device is increased. For example, when a distance D1 between the two adjacent 1^{st} active regions RX1 or a distance D1 between the two adjacent 2^{nd} active regions RX2 is increased, capacitance therebetween may be decreased, a threshold voltage to turn on transistors formed in each of the cells CE11-CE13 may be lowered, and formation of an isolation structure therebetween may become easier in manufacturing the semiconductor device based on the cell block 10A. However, the RXRXV may be fixed in a cell block such as the cell block 10A for a 2D semiconductor device. For example, the distance D 1 is fixed according to a design rule of the cell block 10A for the semiconductor device which is a 2D semiconductor device, and thus, performance increase of the semiconductor device by changing a cell layout may be limited for the cell block 10A.

For example, FIG. 1B shows a layout of a cell block 10B which has the same or similar cell arrangement and cell components of the cell block 10A of FIG. 1A except that, in the cell block 10B, a width W1' of each of the two active regions RX1 and RX2 in the cells CE11' and CE13' is smaller than the width W1 of each of the two active regions RX1 and RX2 in the cell CE12'. This width difference in active region may be implemented to provide at least an area gain to a semiconductor device to be formed based on the cell block 10B, for example, to facilitate formation of other circuit elements in a space between the two active regions having the decreased width W1'.

However, a distance between the two 1^{st} active regions RX1 of the cells CE11' and CE12' and between the two 2^{nd} active regions RX2 of the cells CE12' and CE13' is fixed to the distance D1 as in the cell block 10A of FIG. 1A. Thus, performance increase of the semiconductor device to be formed based on the cell block 10B may also be limited as described above for the cell block 10A.

In contrast, the RXRXV may be changed in a cell layout from a 3D-stacked semiconductor device as described below.

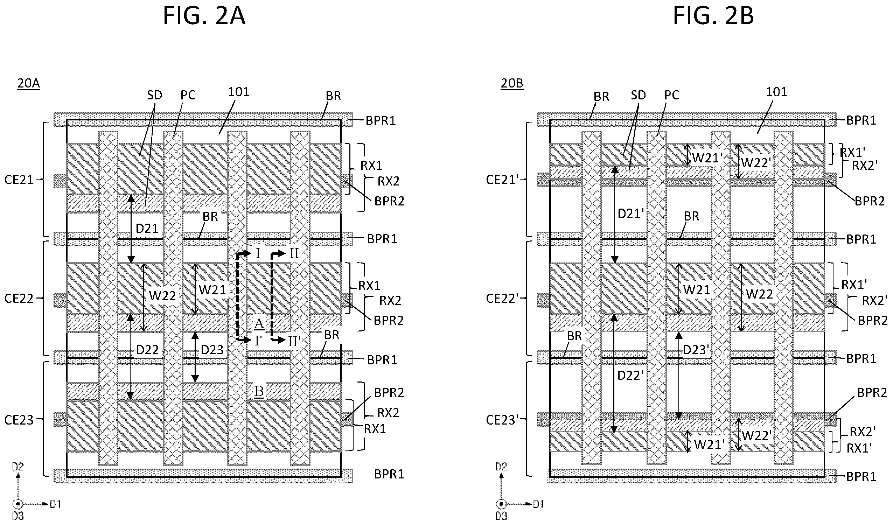

FIG. 2A illustrates a layout of a cell block formed of a plurality of cells for a three-dimensionally-stacked (3D-stacked) semiconductor device, according to one or more embodiments, and FIG. 2B illustrates a layout of a variant of the cell block of FIG. 2A, according to one or more embodiments.

Referring to FIG. 2A, a cell block 20A is formed by serially arranging cells CE21-CE23 in the D2 direction in the same manner as the cells CE11-CE13 of FIG. 1A. These cells CE21-CE23 may have the same or similar cell arrangement and components of the cell block 10A of FIG. 1A. However, the cells CE21-CE23 of the cell block 20A is provided for a 3D-stacked semiconductor device, and thus, an upper active region RX1 is provided for PMOSs and a lower active region RX2 is provided for NMOSs, respectively, in each of the cells CE21-CE23. The upper active region RX1 may partially overlap the lower active region RX2 as will be described later.

Still, however, a plurality of gate structures PC extended in the D2 direction cross the two active regions RX1 and RX2 in each of the cells CE21-CE23. A portion of each of the two active regions RX1 and RX2 in each of the cells CE21-CE23 which a gate structure PC crosses and surrounds may form a channel region of a transistor structure, and two opposite regions in each of the active regions RX1 and RX2 with respect to the gate structure PC in the D1 direction may form source/drain regions connected to each other through the channel region. Thus, these source/drain regions, the channel region and the gate structure may form a PMOS along the upper active region RX1 or an NMOS along the lower active region RX2. Each of the PMOS and NMOS may be a FinFET, a nanosheet transistor, a different type of field-effect transistor or a planar transistor. Also, when a semiconductor device is formed based on the cell block 20A, a region 101 will be a substrate, formed of silicon or its equivalent or a backside isolation structure formed of a dielectric material such as silicon oxide.

As described above, the upper active region RX1 is formed vertically above the lower active region RX2 in a D3 direction to partially overlap the lower active region RX2, and thus, transistors respectively formed in the two active regions RX1 and RX2 may form a 3D transistor structure. Further, a width W21 of the upper active region RX1 may be smaller than a width W22 of the lower active region RX2 in the D2 direction. The upper active region RX1 and the lower active region RX2 may be referred to as an upper active region and a lower active region, respectively, in the D3 direction. Here, the D3 direction refers to a channel height direction which vertically intersects the D1 and D2 directions which horizontally intersect each other.

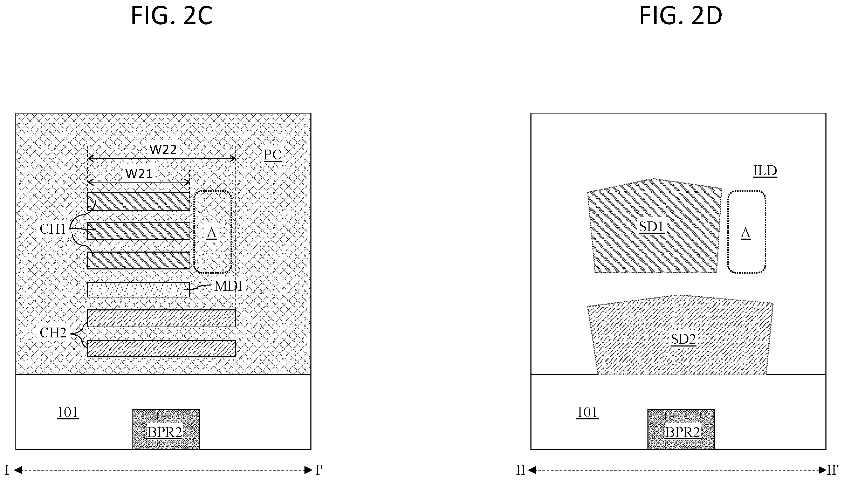

For example, when each transistor formed on the two active regions RX1 and RX2 of each of the cells CE21-CE23 is implemented by a nanosheet transistor, channel structures and source/drain regions formed on the two active regions RX1 and RX2 may take forms shown in FIGS. 2C and 2D. FIG. 2C illustrates an upper channel structure CH1 formed on the upper active region RX1 for an upper nanosheet transistor and a lower channel structure CH2 formed on the lower active region RX2 for a lower nanosheet transistor in a cross-section view taken along a line I-I' shown in FIG. 2A. FIG. 2D illustrates an upper source/drain region SD1 formed on the upper active region RX1 for the upper nanosheet transistor and a lower source/drain region SD2 formed on the lower active region RX2 for the lower nanosheet transistor in a cross-section view taken along a line II-II' shown in FIG. 2A.

Referring to FIGS. 2C and 2D, the upper channel structure CH1 may include a plurality of nanosheet layers having the width W21 which is smaller than the width W22 of a plurality of nanosheet layers forming the lower channel structure CH2. Accordingly, the upper source/drain region SD1 that may be epitaxially grown from the upper channel structure CH1 may have a smaller width than the lower source/drain region SD2 that may be epitaxially grown from the lower channel structure CH2. Due to this width difference in each of the cells CE21-CE23, a region A may be provided along the lower active region RX2 above the lower channel structure CH2 and the lower source/drain region SD2 where the lower active region RX2 including the lower channel structure CH2 and the lower source/drain region SD2 is not overlapped by the upper active region RX1 including the upper channel structure CH1 and the upper source/drain region SD1 in the D3 direction. Due to this region A, which is a non-overlapped region, a contact structure connecting the lower source/drain region SD2 to the voltage source VDD or VSS through the power rails PR1 and PR2 may be formed on a top surface of the lower source/drain region SD2 exposed through the region A.

The channel structures CH1 and CH2 may be surrounded by a gate structure PC and divided by a middle dielectric layer MDI. The source/drain regions SD1 and SD2 may be isolated from each other by an isolation structure ILD.

In the meantime, the 3^{rd} cell CE23 may take a form of a flipped cell which is formed by flipping the 2^{nd} cell CE22 in the D2 direction based on the 2^{nd} boundary of the 2^{nd} cell CE22 which is the 1^{st} boundary of the 3^{rd} cell CE23. As in the cell layout of FIG. 1A, the cell flipping in the cell layout of FIG. 2A may be provided at least to shorten a signal routing path between two upper active regions RX1 or two lower active regions RX2, thereby reducing contact resistance to improve connection performance and a device area gain.

As the 3^{rd} cell CE23 takes a form of a flipped cell of the 2^{nd} cell CE22, the 3^{rd} cell CE23 may be oriented with respect to the 2^{nd} cell CD22 such that the region A above the lower active region RX2 not overlapped by the upper active region RX1 in the 2^{nd} cell CE22 may face a region B above the lower active region RX2 not overlapped by the upper active region RX1 in the 3^{rd} cell CE23, as shown in FIG. 2A. In contrast, the 1^{st} cell CE21 take the same form as the 2^{nd} cell CD22. Thus, a region above the lower active region RX2 overlapped by the upper active region RX1 in the 2^{nd} cell CE22 faces a region above the lower active region RX2 not overlapped by the upper active region RX1 in the 1^{st} cell CE21.

Unlike in the cell block 10A of FIG. 1A where the power rails PR1 and PR2 are formed on the front side of the cell block 10A or the 2D semiconductor device based on the cell block 10A, the cell block 20A may be powered through a plurality of backside power rails BPR1 and BPR2. Placement of backside power rails may not be bound by a cell design rule which strictly requires frontside power rails to be formed on a 1^{st} boundary and a 2^{nd} boundary of a cell. Thus, in the cell block 20A, while a 1^{st} backside power rail BPR1 extended in the D1 direction may be formed to overlap each of a 1^{st} boundary and a 2^{nd} boundary of each cell in the cell block 20A, a 2^{nd} backside power rail BPR2 extended in the D1 direction may be formed to overlap an inside of each cell, for example, a virtual center line extended in the D1 direction in each cell.

The 1^{st} backside power rail BPR1 may connect each cell to a positive voltage source VDD, and the 2^{nd} backside power rail BPR2 may connect the cell to a negative voltage source VSS or ground. These backside power rails BPR1 and BPR2 are included in a BSPDN structure of the 3D-stacked semiconductor device to be formed based on the cell block 20A. The BSPDN structure may be formed on a back side of the 3D-stacked semiconductor device, for example, inside a substrate or a backside isolation structure replacing the substrate in the 3D-stacked semiconductor device.

Like the 2D semiconductor device to be formed based on the cell block 10A, the 3D-stacked semiconductor device to be formed based on the cell block 20A may also be affected in its electrical characteristics, performance, and a manufacturing process thereof by a distance between two adjacent active regions respectively included in two adjacent cells, that is, RXRXV However, unlike in the cell block 10A for the 2D semiconductor device where the RXRXV is fixed, the RXRXV in the cell layout of the cell block 20A may be increased when the cell flipping is performed as shown in FIG. 2A. For example, due to the cell flipping of the cell CE23, a distance D22 between the upper active region RX1 in the cell CE22 and the upper active region RX1 of the flipped cell CE23 may be greater than a distance D21 between the upper active region RX1 in the cell CE22 and the upper active region RX1 of the non-flipped cell CE21. Still, however, a distance D23 between the lower active regions RX2 of two adjacent cells among the cells CE21-CE23 may be fixed without being changed by the cell flipping.

Moreover, when a width of the active region RX1 or RX2 is reduced in the cell block 20A, the RXRXV may be further extended to additionally improve the electrical characteristics, performance, and manufacturing process of the 3D-stacked semiconductor device to be formed based on the cell block 20A.

For example, FIG. 2B shows a layout of a cell block 20B which has the same cell arrangement and cell components of the cell block 20A of FIG. 2A except that a width W21' of upper active regions RX1 and a width W22' of the lower active regions RX2 in a cell CE21' and a flipped cell CE23' are smaller than the width W21 of the upper active region RX1 and the width W22 of the lower active region RX2 in the cell CE22, respectively. This width difference in active region in the D2 direction may also be implemented to provide at least an area gain to a 3D-stacked semiconductor device to be formed based on the cell block 20B, for example, to facilitate formation of other circuit elements in a space between the active regions of the cell block 20B in the D2 direction.

Thus, when the widths of active regions are reduced in the cell block 20B for the 3D-stacked semiconductor device, the RXRXV may be further increased compared to the RXRXV in the cell block 20A. For example, due to the width reduction of the active regions, a distance D22' between an upper active region RX1' in the cell CE22' and the upper active region RX1' of the flipped cell CE23' in the cell block 20B may be greater than the distance D22 between the upper active region RX1 in the cell CE22 and the upper active region RX1 in the flipped cell CE23 in the cell block 20A by the width difference (W21'-W21). Also, a distance D21' between the upper active region RX1' in the cell CE22' and the upper active region RX1' of the cell CE21' in the cell block 20B may be greater than the distance D21 between the upper active region RX1 in the cell CE22 and the upper active region RX1 in the non-flipped cell CE21 in the cell block 20A by the width difference (W21'-W21). Moreover, due to the width reduction of the active regions, a distance D23' between lower active regions RX2' of two adjacent cells among the cells CE21'-CE23' of the cell block 20B may also be greater than the distance D23 between the lower active regions RX2 of two adjacent cells among the cells CE21-CE23 of the cell block 20B by the width difference (W22'-W22).

In the meantime, the RXRXV may be further increased by adding one or more cell spacers according to one or more embodiments provided herebelow.

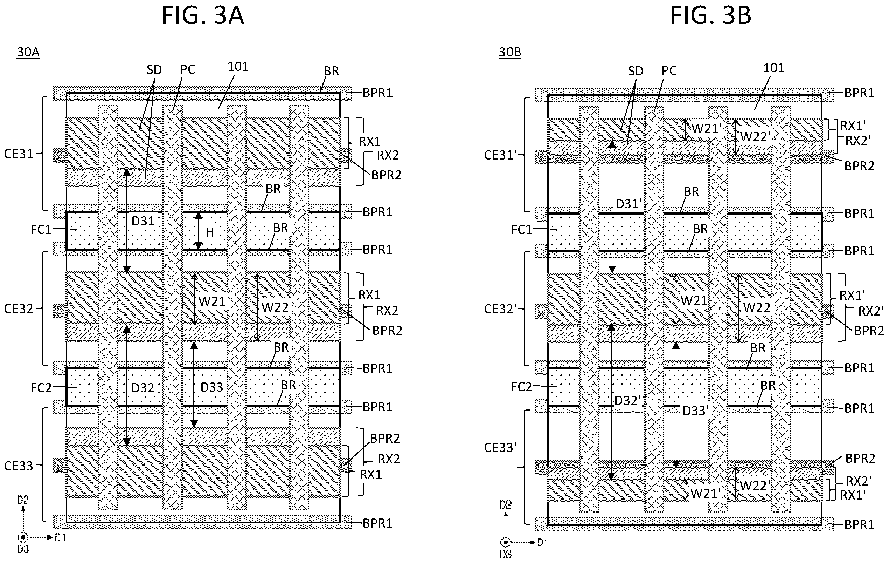

FIGS. 3A illustrates a layout of a cell block formed of a plurality of cells and cell spacers for a 3D-stacked semiconductor device, according to one or more embodiments, and FIG. 3B illustrates a layout of a variant of the cell block of FIG. 3A, according to one or more embodiments.

Referring to FIG. 3A, a cell block 30A is formed of a plurality of cells CE31-CE33 which have the same cell components as the cells CE21-CE23 of the cell block 20A of FIG. 2A. Thus, duplicate descriptions thereof are omitted herein, and instead, different aspects of the cell block 30A are described herebelow.

The cell block 30A differs from the cell block 20A by two cell spacers FC1 and FC2 which are respectively formed between the cells CE31 and CE32 and between the cells CE32 and CE33.

The cell spacers FC1 and FC2 may each have a cell height H which is a distance between a 1^{st} boundary and a 2^{nd} boundary thereof in the D2 direction. Power rails BPR1 may be formed to overlap the 1^{st} and 2^{nd} boundaries of each of the cell spacers FC1 and FC2. For example, the power rails BPR1 may be backside power rails of a BSPDN structure, not being limited thereto.

The cell spacer FC1 and the cell CE31 may abut each other to share a boundary BR such that the 1^{st} boundary of the cell spacer FC1 is or overlaps a 2^{nd} boundary of the cell CE31. The cell spacer FC 1 may also abut the cell CE32 to share a boundary BR such that the 2^{nd} boundary of the cell spacer FC1 is or overlaps a 1^{st} boundary of the cell CE32. Similarly, the cell spacer FC2 may abut each of the cells CE32 and CE33 in the D2 direction to share their boundaries BR.

Each of the cell spacers FC1 and FC2 may not be a void space but a physical cell which does not include active regions such as the upper active region RX1 or the lower active region RX2. However, the gate structure PC may still cross the cell spacers FC1 and FC2 and extended in the D2 direction. For example, the gate structures PC formed on each of the cells CE31-CE33 may be extended in the D2 direction to cross the cell spacers FC1 and FC2 as shown in FIG. 3A.

Due to the cell spacers FC1 and FC2, RXRXV in the cell block 30A may be extended to be greater than the RXRXV in the cell block 20A, thereby to additionally improve electrical characteristics, performance, and a manufacturing process of a 3D-stacked semiconductor device to be formed based on the cell block 30A.

For example, a distance D31 between an upper active region RX1 in a cell CE32 and an upper active region RX1 of a non-flipped cell CE31 in the cell block 30A may be greater than the distance D21 between the upper active region RX1 in the cell CE22 and the upper active region RX1 of the non-flipped cell CE21 in the cell block 20A by the cell height H of the cell spacer FC1. Likewise, a distance D32 between the upper active region RX1 in the cell CE32 and an upper active region RX1 of a flipped cell CE33 in the cell block 30A may be greater than the distance D22 between the upper active region RX1 in the cell CE22 and the upper active region RX1 of the flipped cell CE23 in the cell block 20A by the cell height H of the cell spacer FC2. A distance D33 between the lower active regions RX2 of two adjacent cells among the cells CE31-CE33 in the cell block 30A may also be greater than the distance D23 in the cell block 20A by the cell height H of the cell spacer FC1 or FC2.

The RXRXV in the cell block 30A may be additionally extended as shown in FIG. 3B by reducing widths of active regions in selective cells of the cell block 30A.

Referring to FIG. 3B, the cell block 30B is formed of a plurality of cells CE31'-CE33' which have the same cell components as the cells CE21'-CE23' of the cell block 20B of FIG. 2B. Thus, duplicate descriptions thereof are omitted herein, and instead, different aspects of the cell block 30B are described herebelow.

In a layout of the cell block 30B, a width W21' of upper active regions RX1' and a width W22' of lower active regions RX2' in the cell CE31' and the flipped cell CE33' are smaller than the width W21 of the upper active region RX1 and the width W22 of the lower active region RX2 in the cell CE32 of the cell block 30A, respectively. As described earlier in reference to FIG. 2B, this width difference in active region in the D2 direction may also be implemented to provide at least an area gain to a 3D-stacked semiconductor device to be formed based on the cell block 30B, for example, to facilitate formation of other circuit elements in a space between the active regions of the cell block 30B in the D2 direction. However, when the widths of active regions are reduced to form the cell block 30B for a 3D-stacked semiconductor device, the RXRXV may be further increased compared to the RXRXV in the cell block 30A.

For example, due to the width reduction of the active regions, a distance D32' between an upper active region RX1' in a cell CE32' and the upper active region RX1' of the flipped cell CE33' in the cell block 30B may be greater than the distance D32 between the upper active region RX1 in the cell CE32 and the upper active region RX1 in the flipped cell CE33 in the cell block 30Aby the width difference (W21'-W21). Also, a distance D31' between the upper active region RX1' in the cell CE32' and the upper active region RX1' of the non-flipped cell CE31' in the cell block 30B may be greater than the distance D31 between the upper active region RX1 in the cell CE32 and the upper active region RX1 in the non-flipped cell CE31 in the cell block 20A by the width difference (W21'-W21). Moreover, due to the width reduction of the active regions, a distance D33' between lower active regions RX2' of two adjacent cells among the cells CE31'-CE33' of the cell block 30B may also be greater than the distance D33 between the lower active regions RX2 of two adjacent cells among the cells CE31-CE33 of the cell block 30B by the width difference (W22'-W22).

The cell block 30B may also be obtained by adding the cell spacer FC1 and FC2 in the cell block 20B of FIG. 2B. By forming the cell spacers FC1 and FC2 between the cells CE21' and CE22' and between the cells CE22' and CE23', the cell block 20B may take the same layout as the cell block 30B.

Thus, the distance D31' between the upper active region RX1' in a cell CE32' and the upper active region RX1' of the non-flipped cell CE31' in the cell block 30B may be greater than the distance D21' between the upper active region RX1' in the cell CE22' and the upper active region RX1' of the non-flipped cell CE21' in the cell block 20B by a cell height H of the cell spacer FC1. Likewise, the distance D32' between the upper active region RX1' in the cell CE32' and the upper active region RX1' of the flipped cell CE33' in the cell block 30B may be greater than the distance D22' between the upper active region RX1' in the cell CE22' and the upper active region RX1' of the flipped cell CE23' in the cell block 20B by the cell height H of the cell spacer FC2. The distance D33' between the lower active regions RX2' of two adjacent cells among the cells CE31'-CE33' in the cell block 30B may also be greater than the distance D23' in the cell block 20B by the cell height H of the cell spacer FC1 or FC2.

Due to the cell spacers FC1 and FC2 and the width differences, the RXRXV in the cell block 30B may be greater than the RXRXV in the cell blocks 20B and 30A to further improve electrical characteristics, performance, and a manufacturing process of a 3D-stacked semiconductor devices formed based on the cell block 30B.

In the meantime, each of the cell blocks 30A and 30B may include both the cell spacer FC1 and the cell spacer FC2. However, one of the two cell spacers FC1 and FC2 may not be formed according to one or more other embodiments. For example, the cell spacer FC2 may not be formed between the cells CE32 and CE33 and between the cells CE32' and CE33' considering that the RXRXV thereof is sufficiently large, and thus, formation of the cell spacer FC2 may be determined to only increase the size of the cell blocks 30A and 30B.

In the above embodiments, the cell spacers FC1 and FC2 are added between two adjacent cells in which the width of the upper active region RX1 or RX1' is smaller than the width of the lower active region RX2 or RX2', respectively, in the D2 direction. However, the disclosure is not limited thereto, and the cell spacers FC1 and FC2 may also be added between the two adjacent cells even when the upper active region RX1 or RX1' and the lower active region RX2 or RX2' have the same width in the D2 direction to increase the RXRXV, according to one or more embodiments. For example, in the layout of the cell block 30B shown in FIG. 3B, at least one of the cells CE31' and CE32' may have two active regions RX1 and RX2 having the same width in the D2 direction.

In the above embodiments of FIGS. 2A-2B and 3A-3B for the 3D-stacked semiconductor device, the RXRXV is described as between two adjacent active regions of respective two PMOSs at a same level or stack (e.g., upper active regions RX1 or RX1' of upper transistors) of the 3D-stacked semiconductor device. However, the disclosure of cell flipping, cell-width reduction, and cell spacer may also apply to RXRXV between two adjacent active regions of respective two NMOSs (e.g., lower active regions RX2 or RX2' of lower transistors). Further, the disclosure may also apply to RXRXV between two adjacent active regions of respective different-polarity two transistors. For example, it is understood from FIGS. 2A-2B and 3A-3B that, when the RXRXV between two adjacent active regions of the same-polarity transistors at a same level or stack (e.g., PMOSs or NMOSs) is increased, a distance between two adjacent active regions of different polarity-transistors at different levels or stacks (e.g., RXRXV between an RX1 and an RX2) also increases.

In the above embodiments, the cell block is formed of only three cells serially arranged in the D2 direction. However, this number of the cells is only an example, and thus, one or more cells, whether they are flipped cells of one of the three cells or not, may be added to the cell block in the D2 direction, according to one or more embodiments.

In the above embodiments, the upper active region RX1 or RX1' and the lower active region RX2 or RX2' are provided to form PMOSs and NMOSs, respectively. However, the disclosure is not limited thereto, and each of the two active regions RX1 or RX1' and RX2 or RX2' may be provided to form PMOSs or NMOSs, according to one or more other embodiments. For example, the upper active region RX1 or RX1' may be provided to form NMOSs while the lower active region RX2 or RX2' is provided to form PMOSs.

In the above embodiments, the 1^{st} power rail PR1 and the 1^{st} backside power rail BPR1 are each connected to the positive voltage source VDD, and the 2^{nd} power rail PR2 and the 2^{nd} backside power rail BPR2 are each connected to the negative voltage source VSS or ground. However, the disclosure is not limited thereto. According to one or more other embodiments, the 1^{st} power rail PR1 and the 1^{st} backside power rail BPR1 may each be connected to the negative voltage source VSS or ground, and the 2^{nd} power rail PR2 and the 2^{nd} backside power rail BPR2 may each be connected to the positive voltage source VDD. Further, according to one or more other embodiments, instead of the backside power rails BPR1 and BPR2, the power rails PR1 and PR2, which are frontside power rails, may be formed on the 1^{st} and 2^{nd} boundaries of the cells in the cell blocks 20A, 20B, 30A and 30B.

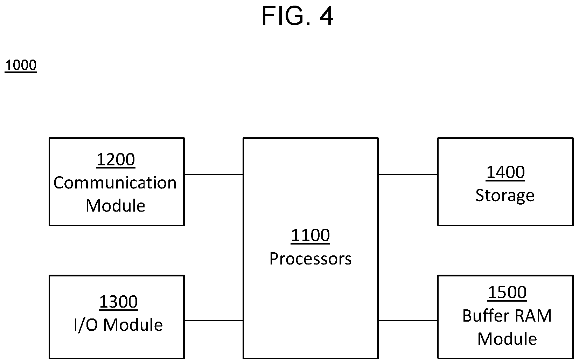

FIG. 4 is a schematic block diagram illustrating an electronic device including at least one 3D-stacked semiconductor device formed based on at least one of the cell blocks 20A, 20B, 30A and 30B shown in FIGS. 2A, 2B, 3A and 3B, according to embodiments.

Referring to FIG. 4, an electronic device 1000 may include at least one processor 1100, a communication module 1200, an input/output module 1300, a storage 1400, and a buffer random access memory (RAM) module 1500. The electronic device 1000 may be a mobile device such as a smartphone or a tablet computer, not being limited thereto, according to embodiments.

The processor 1100 may include a central processing unit (CPU), a graphic processing unit (GPU) and/or any other processors that control operations of the electronic device 1000. The communication module 1200 may be implemented to perform wireless or wire communications with an external device. The input/output module 1300 may include at least one of a touch sensor, a touch panel a key board, a mouse, a proximate sensor, a microphone, etc. to receive an input, and at least one of a display, a speaker, etc. to generate an output signal processed by the processor 1100. The storage 1400 may be implemented to store user data input through the input/output module 1300, the output signal, etc. The storage 1400 may be an embedded multimedia card (eMMC), a solid state drive (SSD), a universal flash storage (UFS) device, etc.

The buffer RAM module 1500 may temporarily store data used for processing operations of the electronic device 1000. For example, the buffer RAM 1500 may include a volatile memory such as double data rate (DDR) synchronous dynamic random access memory (SDRAM), low power double data rate (LPDDR) SDRAM, graphics double data rate (GDDR) SDRAM, Rambus dynamic random access memory (RDRAM), etc.

Although not shown in FIG. 4, the electronic device 1000 may further include at least one sensor such as an image sensor.

At least one component in the electronic device 1000 may be formed based on at least one of the 3D-stacked semiconductor device formed based on at least one of the cell blocks 20A, 20B, 30A and 30B shown in FIGS. 2A, 2B, 3A and 3B, according to embodiments.

The foregoing is illustrative of example embodiments and is not to be construed as limiting the disclosure. Although a few example embodiments have been described, those skilled in the art will readily appreciate that many modifications are possible in the above embodiments without materially departing from the disclosure.

## Claims

1. A semiconductor device based on a cell block which comprise:
a 1^{st} cell comprising a 1^{st} lower active region and a 1^{st} upper active region extended in a 1^{st} direction, a width of the 1^{st} upper active region being smaller than a width of the 1^{st} lower active region in a 2^{nd} direction, and the 1^{st} upper active region partially overlapping the 1^{st} lower active region in a 3^{rd} direction; and
a 2^{nd} cell abutting the 1^{st} cell in the 2^{nd} direction, and comprising a 2^{nd} lower active region and a 2^{nd} upper active region extended in the 1^{st} direction, a width of the 2^{nd} upper active region being smaller than a width of the 2^{nd} lower active region in the 2^{nd} direction, and the 2^{nd} upper active region partially overlapping the 2^{nd} lower active region in the 3^{rd} direction,
wherein the 3^{rd} direction vertically intersects the 1^{st} direction and the 2^{nd} direction which horizontally intersect each other, and
wherein the 2^{nd} cell is oriented with respect to the 1^{st} cell in the 2^{nd} direction such that a 1^{st} region, above the 1^{st} lower active region, not overlapped by the 1^{st} upper active region in the 1^{st} cell faces a 2^{nd} region, above the 2^{nd} lower active region, not overlapped by the 2^{nd} upper active region in the 2^{nd} cell, in the 2^{nd} direction.

2. The semiconductor device of claim 1, wherein each of a 1^{st} boundary and a 2^{nd} boundary, opposite to each other in the 2^{nd} direction, of each of the 1^{st} cell and the 2^{nd} cell overlaps a 1^{st} power rail connected to one of a positive voltage source and a negative voltage source in the 3^{rd} direction.

3. The semiconductor device of claim 2, wherein a 2^{nd} power rail is formed to overlap an inside of each of the 1^{st} cell and the 2^{nd} cell in the 3^{rd} direction, and
wherein the 2^{nd} power rail connects at least one of the 1^{st} cell and the 2^{nd} cell to the other of the positive voltage source and the negative voltage source.

4. The semiconductor device of claim 1, further comprising a plurality of backside power rails connecting the 1^{st} cell and the 2^{nd} cell to one or more voltage sources,
wherein at least one of the plurality of backside power rails overlaps an inside of at least one of the 1^{st} cell and the 2^{nd} cell in the 3^{rd} direction.

5. The semiconductor device of any one of claims 1 to 4, wherein the width of the 2^{nd} upper active region is different from the width of the 1^{st} upper active region, and.
wherein the width of the 2^{nd} lower active region is different from the width of the 1^{st} lower active region.

6. The semiconductor device of any one of claims 1 to 5, further comprising:
a 3^{rd} cell abutting the 1^{st} cell in the 2^{nd} direction, and comprising a 3^{rd} lower active region and a 3^{rd} upper active region extended in the 1^{st} direction, a width of the 3^{rd} upper active region being smaller than a width of the 3^{rd} lower active region in the 2^{nd} direction, and the 3^{rd} upper active region partially overlapping the 3^{rd} lower active region in the 3^{rd} direction,
wherein the 1^{st} cell is disposed between the 2^{nd} cell and the 3^{rd} cell in the 2^{nd} direction, and,
wherein a 3^{rd} region above the 1^{st} lower active region overlapped by the 1^{st} upper active region in the 1^{st} cell faces a 4^{th} region above the 3^{rd} lower active region not overlapped by the 3^{rd} upper active region in the 3^{rd} cell, in the 2^{nd} direction.

7. The semiconductor device of claim 6, wherein the width of the 2^{nd} upper active region is different from at least one of the width of the 1^{st} upper active region and the width of the 3^{rd} upper active region in the 2^{nd} direction, and
wherein the width of the 2^{nd} lower active region is different from at least one of the width of the 1^{st} lower active region and the width of the 3^{rd} lower active region in the 2^{nd} direction.

8. A semiconductor device based on a cell block which comprises:
a 1^{st} cell comprising a 1^{st} lower active region and a 1^{st} upper active region extended in a 1^{st} direction, a width of the 1^{st} upper active region being smaller than a width of the 1^{st} lower active region in a 2^{nd} direction, and the 1^{st} upper active region partially overlapping the 1^{st} lower active region in a 3^{rd} direction; and
a 2^{nd} cell abutting the 1^{st} cell in the 2^{nd} direction, and comprising a 2^{nd} lower active region and a 2^{nd} upper active region extended in the 1^{st} direction, a width of the 2^{nd} upper active region being smaller than a width of the 2^{nd} lower active region in the 2^{nd} direction, and the 2^{nd} upper active region partially overlapping the 2^{nd} lower active region in the 3^{rd} direction,
wherein the 3^{rd} direction vertically intersects the 1^{st} direction and the 2^{nd} direction which horizontally intersect each other,
wherein the width of the 2^{nd} upper active region is smaller than the width of the 1^{st} upper active region, and
wherein the width of the 2^{nd} lower active region is smaller than the width of the 1^{st} lower active region.

9. The semiconductor device of claim 8, wherein a region, above the 1^{st} lower active region, overlapped by the 1^{st} upper active region in the 1^{st} cell faces a region, above the 2^{nd} lower active region, not overlapped by the 2^{nd} upper active region in the 2^{nd} cell, in the 2^{nd} direction.

10. The semiconductor device of claim 8, wherein the 2^{nd} cell is oriented with respect to the 1^{st} cell in the 2^{nd} direction such that a 1^{st} region, above the 1^{st} lower active region, not overlapped by the 1^{st} upper active region in the 1^{st} cell faces a 2^{nd} region, above the 2^{nd} lower active region, not overlapped by the 2^{nd} upper active region in the 2^{nd} cell, in the 2^{nd} direction.

11. The semiconductor device of claim 10, further comprising a 3^{rd} cell abutting the 1^{st} cell in the 2^{nd} direction, and comprising a 3^{rd} lower active region and a 3^{rd} upper active region, both being extended in the 1^{st} direction, a width of the 3^{rd} upper active region being smaller than a width of the 3^{rd} lower active region in the 2^{nd} direction, and the 3^{rd} upper active region partially overlapping the 3^{rd} lower active region in the 3^{rd} direction,
wherein the 1^{st} cell is disposed between the 2^{nd} cell and the 3^{rd} cell in the 2^{nd} direction, and,
wherein a 3^{rd} region above the 1^{st} lower active region overlapped by the 1^{st} upper active region in the 1^{st} cell faces a region above the 3^{rd} lower active region not overlapped by the 3^{rd} upper active region in the 3^{rd} cell, in the 2^{nd} direction.

12. The semiconductor device of any one of claims 8 to 11, further comprising a plurality of backside power rails connecting the 1^{st} cell and the 2^{nd} cell to one or more voltage sources,
wherein at least one of the plurality of backside power rails overlaps an inside of at least one of the 1^{st} cell and the 2^{nd} cell.

13. A semiconductor device based on a cell block which comprises:
a 1^{st} cell comprising a 1^{st} lower active region and a 1^{st} upper active region above the 1^{st} lower active region in a 3^{rd} direction, both being extended in a 1^{st} direction;
a 2^{nd} cell comprising a 2^{nd} lower active region and a 2^{nd} upper active region above the 2^{nd} lower active region in the 3^{rd} direction, both being extended in the 1^{st} direction; and
a cell spacer between the 1^{st} cell and the 2^{nd} cell in a 2^{nd} direction,
wherein no active region is formed in the cell spacer, and
wherein the 3^{rd} direction vertically intersects the 1^{st} direction and the 2^{nd} direction which horizontally intersect each other.

14. The semiconductor device of claim 13, wherein the cell spacer comprises one or more gate structures.

15. The semiconductor device of claim 14, wherein the one or more gate structures are connected to one or more gate structures in the 1^{st} cell, respectively, in the 2^{nd} direction.
